# EUROPEAN PATENT APPLICATION

(11) **EP 2 884 553 A1**
(43) Date of publication of application: **17.06.2015**
(21) Application number: 13196631.9
(22) Date of filing: 11.12.2013
(51) Int. Cl.: H01L 51/52

(54) **Method and system for providing a carrier with an embedded patterned metal structure**

(71) Applicant: Nederlandse Organisatie voor toegepast- natuurwetenschappelijk onderzoek TNO, 2595 DA 's-Gravenhage (NL)
(72) Inventor: Andriessen, Hieronymus Antonius Josephus Maria, 2628 VK Delft (NL); Mandamparambil, Rajesh, 2628 VK Delft (NL); Gilot, Jan, 2628 VK Delft (NL)
(74) Representative: Jansen, Cornelis Marinus

(57) **Abstract**

A method is presented for providing a carrier (CR) with an embedded patterned metal structure (EMM). The carrier at least includes a polymer foil (FS). The method comprise the steps of providing a carrier (CR) having a first side (S1) with an initial embedded patterned metal structure (EM). The carrier is then irradiated at a second side (S2) opposite the first side with a radiation beam (BM) that is at least partially transmitted through the carrier (CR) and at least partially absorbed by the initial embedded patterned metal structure (EM), therewith locally heating the initial embedded patterned metal structure and causing a removal of metal (DB) from the initial embedded patterned metal structure.

## Description

### BACKGROUND OF THE INVENTION

### Field of the invention

The present invention relates to a method for providing a polymer foil with an embedded patterned metal structure.

The present invention further relates to a system for providing a polymer foil with an embedded patterned metal structure.

### Related Art

WO2010/016763 discloses a method of providing a polymer foil with an embedded patterned metal structure. The polymer foil prepared therewith can be used as a semi-finished product for manufacturing various electronic products, such as electro-optical products. Therein the embedded patterned metal structure may serve as an electronic conductor to support functioning of the product. This applies in particular to electro-optical products, which require at least one transparent electrode, such as an ITO-layer. The requirement of transparency puts restrictions on the thickness of the electrode, and therewith on its conductivity. Typically therefore the transparent electrode is supported by a patterned metal structure. An embedded patterned metal structure has the advantage that it can have a high topology to contain sufficient volume to conduct a large current, while it allows electro-magnetic radiation, in particular light or infrared radiation, to pass through openings in the pattern. In OLEDS an embedded patterned metal structure typically serves as a power supply grid to support a transparent electrode. Analogously, in solar cell modules the embedded patterned metal structure typically serves as a power collection grid coupled to a transparent electrode. Patterning of these metal structures can be done on beforehand by selective deposition of the metal structure.

Consumer requirements as well as product specifications change in time. Accordingly a specific pattern of a metal structure of a semi-finished product on stock may no longer be suitable for manufacturing new products. Accordingly, there is a need to provide a means to adapt the semi-finished product to match changes in the product requirements.

### SUMMARY OF THE INVENTION

According to a first aspect of the invention a method is provided for providing a carrier with an embedded patterned metal structure. The carrier comprises at least a polymer foil and may include additional layers. The method comprising the steps of
- providing a carrier having a first side with an initial embedded patterned metal structure,
- irradiating the carrier at a second side opposite the first side with a radiation beam that is at least partially transmitted through the carrier and at least partially absorbed by the initial embedded patterned metal structure, therewith locally heating the initial embedded patterned metal structure and causing a removal of metal from the initial embedded patterned metal structure.

In an embodiment the first side of the carrier faces downwards at the location where the carrier is irradiated. Gravity then facilitates removal of debris resulting from the removal of metal. Alternatively or in addition, a suction device may be provided to facilitate removal of debris.

Although ideally a wavelength is used for which the all radiation is transmitted by the carrier and subsequently completely absorbed by the metal of the initial embedded patterned metal structure, it is sufficient if the applied radiation is at least partially transmitted by the carrier and at least partially absorbed by the metal of the initial embedded patterned metal structure. A lower transmission of the carrier and a lower absorption of the metal can be compensated by an increased power density of the applied radiation. The carrier may for example transmit at least 50% of the radiation, and the metal may absorb for example at least 50% of the radiation. To that end a wavelength or a wavelength band selected in the infrared range is suitable, e.g. selected from the range between 500 nm to 2500 nm. Various polymeric materials have a low absorption of radiation in this wavelength range, while the absorption of radiation in this wavelength range for the metal is relatively high. More preferably the wavelength or wavelength band may be selected in the range of 500 nm to 1100 nm.

Dependent on the required detail the radiation beam may impinge within a spot on the second side of the carrier having a spot-size in the range of e.g. 10 to 500 micron. The spot-size is defined according to the full-width half height measure (FWHH). The emitted power may be selected in a range of 0.1 J/cm² for relatively thin initial embedded patterned metal structure to 10 J/cm² for relatively thick initial embedded patterned metal structure.

The spot may be scanned within a target range. The target range may for example be an area, e.g. a rectangular area. Alternatively, the target range may be a target line. In this case a true two-dimensional area of the carrier may be covered by transporting the carrier in a direction transverse to the direction of the target line. In again an alternative embodiment the target range may be single spot and transport facilities may be provided to transport the carrier in mutually transverse directions to achieve that a true two-dimensional area of the carrier is covered.

In an embodiment the radiation is applied pulse-wise. This has the advantage that the region heated by the radiation beam impinging on the metal of the metal layer can be narrowed.

The embedded metal structure is arranged within the carrier, but has a free surface at said first side. The free surface of the embedded metal structure does not need to coincide with the surface of the carrier, but may be sunken into the surrounding surface of the carrier or extend somewhat outside the surface

As indicated above, the carrier typically transmits at least 50% of the radiation impingent on the polymer foil arrives at the embedded patterned metal structure. Preferably the radiation in the first wavelength range is substantially not reflected, e.g. preferably the initial embedded patterned metal structure reflects less than 10% of the radiation impinging thereon. However a certain amount of reflection e.g. upto 50% may be compensated by increasing an intensity of the radiation source.

The present invention is particularly interesting for organic electronics with a patterned metallic grid structure for current collection or injection like organic photovoltaics (OPV) or organic light emitting diodes (OLED).

### BRIEF DESCRIPTION OF THE DRAWINGS

These and other aspects are described in more detail with reference to the drawing. Therein:
FIG. 1A and 1B show a first embodiment of product suitable to be processed with a method and system according to the present invention; Therein FIG. 1A shows a cross-section and FIG. 1B shows a top-view according to IB in FIG. 1A,
FIG. 1C to 1F shows according to the same top-view a plurality of other products suitable to be processed,
FIG. 2A and 2B show in a cross-section alternative examples of products suitable to be processed with a method and system according to the present invention,
FIG. 3 shows an example of an electro-optical product that may be obtained from a product as with a method and system according to the present invention,
FIG. 4A to 4D illustrate a method according to the present invention; Therein FIG. 4A shows a top-view of a carrier with an initial embedded patterned metal structure, FIG. 4B shows a cross-section according to B,C of this carrier, FIG. 4C shows in the same cross-section the effects of application of a step of the inventive method, and FIG. 4D shows the carrier with the resulting embedded patterned metal structure according to the same top-view as FIG. 4A,
FIG. 5 shows an example of an alternative resulting embedded patterned metal structure,
FIG. 6 shows an embodiment of a system according to the present invention,
FIG. 6A shows a cross-section of a variation of this embodiment,
FIG. 6B schematically shows an alternative embodiment of a system according to the present invention,
FIG. 6C schematically shows another alternative embodiment of a system according to the present invention
FIG. 7A, 7B, 7C illustrate results of a first experiment obtained with a method according to the present invention,
FIG. 8A, 8B illustrate results of a second experiment obtained with a method according to the present invention,
FIG. 9 illustrate results of an experiment obtained with a method not according to the present invention.

### DETAILED DESCRIPTION OF EMBODIMENTS

Like reference symbols in the various drawings indicate like elements unless otherwise indicated.

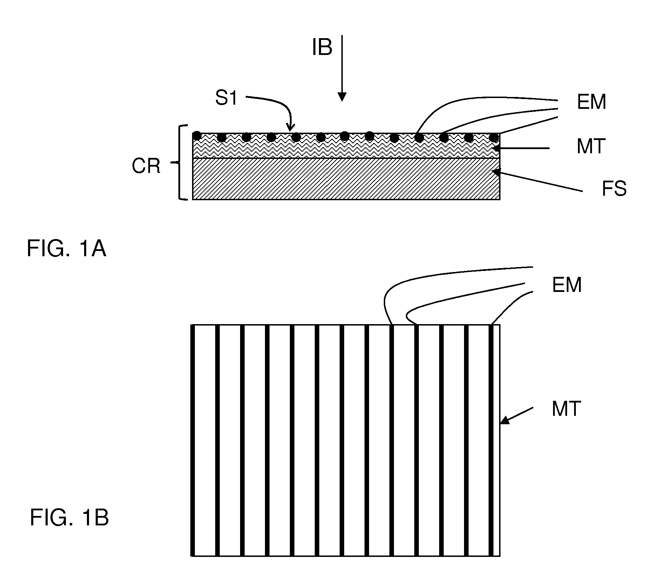

FIG. 1A shows an example of a carrier CR having a first side S1 with an initial embedded patterned metal structure EM. More in particular the carrier CR comprises a polymer foil FS that is provided with a layer MT of an organic material wherein the patterned metal structure EM is embedded.

FIG. 1B shows a top-view according to IB in FIG. 1A. Therein it can be seen that the embedded patterned metal structure EM is formed as a set of parallel lines.

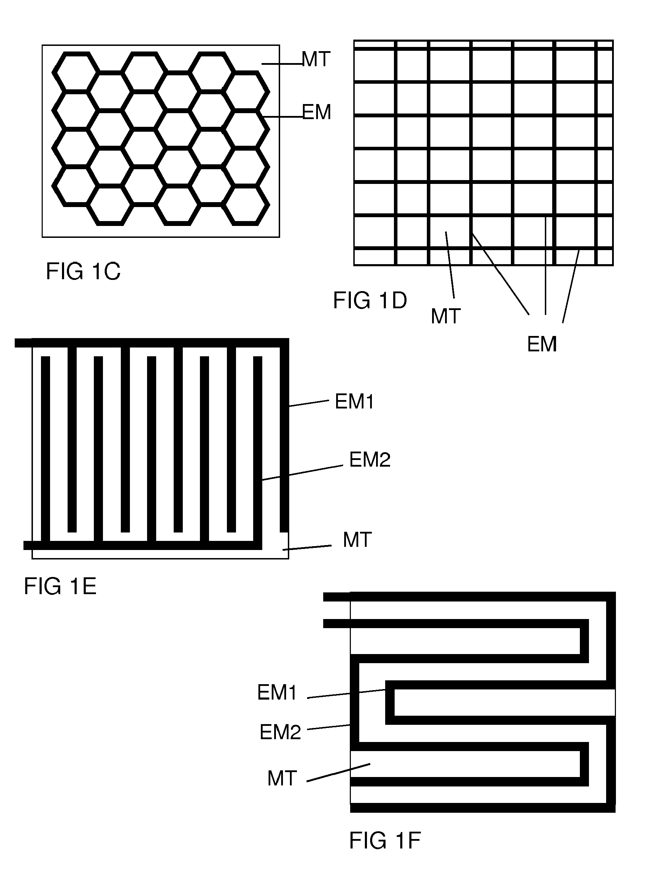

FIG. 1C to 1F show examples of alternative topologies. In FIG. 1C and 1D the embedded patterned metal structure EM is formed as a hexagonal grid and as a rectangular grid respectively. The embedded patterned metal structure may comprise mutually disconnected parts EM1, EM2 as shown for example in FIG. 1E and 1F.

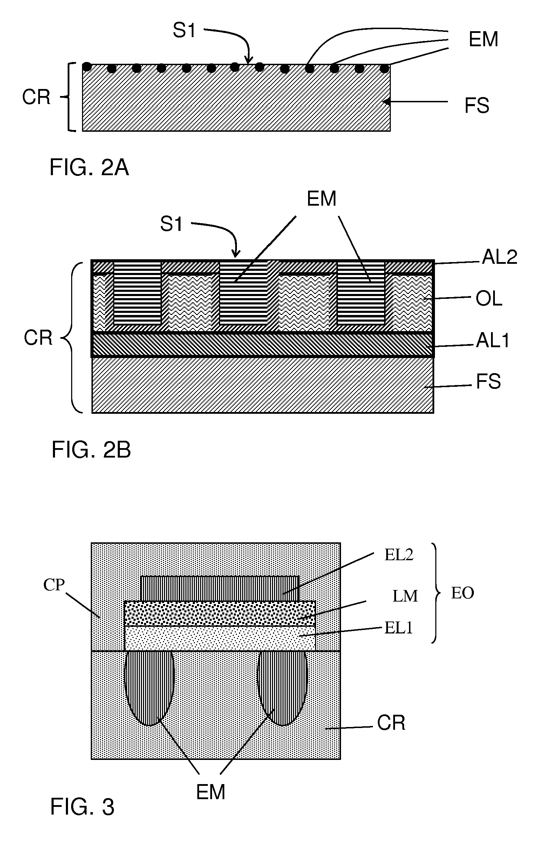

While in the example as shown in cross-section in FIG. 1A the embedded patterned metal structure EM is embedded in a separate layer MT of an organic material, the patterned metal structure EM may alternatively be embedded in the polymer foil itself as shown in FIG. 2A. Still alternatively the patterned metal structure EM may be embedded in a stack of layers. FIG. 2B shows an example wherein the stack of layers is a barrier structure that comprises a first inorganic layer AL1, an organic layer OL, and a second inorganic layer AL2. In other cases a single barrier layer of an inorganic layer may suffice instead of a barrier structure.

If desired, for example for application in a hostile atmosphere, it may also be considered to use more layers, for example in the form of a multilayer barrier subsequently comprising AL1, OL1, AL2, OL2, AL3, wherein AL1, AL2, AL3 are inorganic layers and OL1, OL2 are organic layers.

The first and/or second inorganic layer(s) may be any translucent ceramic including but not limited to metal oxide, metal nitride, metal carbide, metal oxynitride, such as silica or silicon oxide (SiO2), alumina or aluminum oxide (Al2O3), titania or titanium oxide (TiO2), indium oxide (In203), tin oxide (SnO2), indium tin oxide (ITO, In203+SnO2), aluminaum nitride (AIN), silicon nitride (SiN), silicon carbide (SiC), silicon oxynitride (SiON), indium oxide (In2O3), tin oxide (SnO2), indium tin oxide (ITO) and combinations thereof. Suitable organic materials for this purpose may include, but are not limited to
- (poly)alkoxy silanes (examples of which include, but are not limited to: 3-trimethoxysilylpropylmethacrylate),
- (poly)acrylates
- (poly)isocyanates (examples of which include, but are not limited to: poly[(phenyl isocyanate)-co-formaldehyde]),
- (poly)oxazolidines (examples of which include, but are not limited to: 3-ethyl-2-methyl-2-(3-methylbutyl)-1,3-oxazolidine (Zoldine® MS-PLUS)),
- (poly)anhydrides,
- (poly)cyanoacrylates,
- linear polysugars (examples of which include, but are not limited to: polysaccharides, cellulose, hydroxyethylcellulose),
- cyclic polysugars (examples of which include, but are not limited to: cyclodextrins).

Also barrier structures are suitable that have no organic layers between the inorganic layers. For example barrier structures may be applied having a stack comprising ceramic layers of mutually different nature that alternate each other, for example a stack comprising silicon nitride (N) and silicon oxide (O) layers that alternate each other, for example according to the pattern NONON.

The embedded patterned metal structure EM may have been obtained from various metals or their precursors. Suitable metals are for example cupper, aluminium, tin, silver etc. Suitable precursors are metal complex solutions of such metals and inks comprising nano/micro-particles or flakes of these metals. Metals such as tin and silver are advantageous in that they can be easily applied in a molten form, due to their low melting point. Silver, cupper and aluminum are particularly advantageous in view of their low electrical resistance.

The polymer foil is preferably from a resin base material. Such resin base materials preferably include polyethylene terephthalate (PET), polyethylene naphthalate (PEN), polyimide (PI), polyetherimide (PEI), polyethersulfone (PES), polysulfone (PSF), polyphenylene sulfide (PPS), polyether ether ketone (PEEK), polyarylate (PAR), and polyamide-imide (PAI). Other resin materials include polycycloolefin resin, acrylic resin, polystyrene, ABS, polyethylene, polypropylene, polyamide resin, polyvinyl chloride resin, polycarbonate resin, polyphenyleneether resin and cellulose resin, etc.

Starting from a carrier CR as described with reference to the previous figures, a electronic product on foil may manufactured as shown for example in FIG. 3. In the example shown therein the electronic product is an electro-optical device EO encapsulated between an encapsulation part CP and the carrier CR. In the example shown the electro-optical device EO is an OLED having a first, transparent electrode EL1 (e.g. a transparent inorganic layer, such as indium tin oxide, doped zinc oxide or a transparent organic layer, such as PEDOT), a luminescent layer LM and a second electrode EL2. In practice the luminescent layer LM may be composed of sub-layers and additional layers may be provided such as hole-transport-layers and electron-transport-layers.

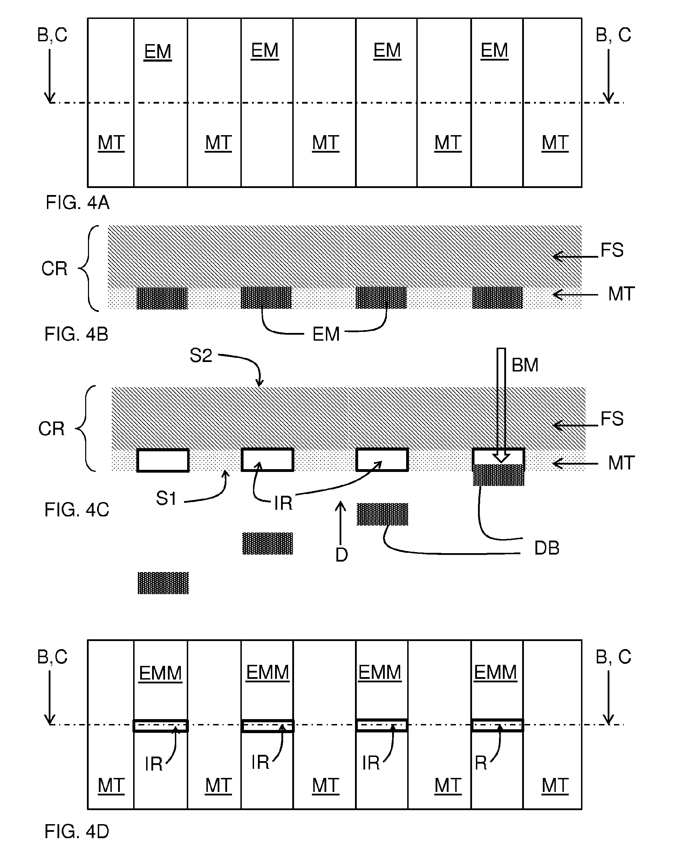

A method according to the present invention to modify the embedded patterned metal structure EM is now described in more detail with reference to FIG. 4A to 4D. Therein FIG. 4A shows a top-view of a carrier having an initial embedded patterned metal structure EM as shown in FIG. 1A, 1B. The top-view shows the first side of the carrier CR where the patterned metal structure EM is embedded. The method is however equally applicable to modify other initial embedded patterned metal structures, for example those as shown in and described with reference to FIG. 2A to 2F and FIG. 3A and 3B.

FIG. 4B shows a cross-section according to B,C-B,C in FIG. 4A.

As shown in FIG. 4C, according to the same cross-section, the carrier CR is irradiated at a second side S2 opposite the first side S1 with a radiation beam BM. The radiation of the radiation beam is at least partially transmitted through the carrier CR and at least partially absorbed by the initial embedded patterned metal structure EM. The radiation beam is for example emitted by a laser in the infrared wavelength range e.g. having a wavelength in the range between 800 nm to 2500 nm. Radiation within this wavelength range is substantially transmitted by most polymers and most translucent ceramic materials referred to above. At the same time radiation in this wavelength range is typically well absorbed by most metals. Nevertheless, in some cases alternatively radiation in other wavelength ranges may be used. Copper for example, also has a relatively high absorption for some ranges in the visible spectrum. The radiation beam BM locally heats the initial embedded patterned metal structure EM. This local heat developed causes a removal of metal (DB) from the initial embedded patterned metal structure. Therewith a modified embedded patterned metal structure EMM is obtained that has interruptions IR. The heat locally developed in the embedded metal layer may cause a full evaporation of the locally present metal. Alternatively solid or molten metal parts DB as shown in FIG. 4C may be blast away by vaporized metal. The exact nature of the removal process depends on the power distribution as a function of time. If the radiation is provided pulse-wise at a relatively short pulse duration and with a relatively high power density, the radiation will typically evaporate a superficial layer of initial embedded patterned metal structure facing the radiation beam BM, at the location where the radiation beam BM impinges on the initial embedded patterned metal structure. The metal vapor then blasts the remainder of the metal layer at that location, which may be partially or fully melted, away from the initial embedded patterned metal structure. If the radiation is provided with a relatively low power density in a continuous manner or pulse-wise at a relatively large pulse duration, metal at the impingement location tends to be fully vaporized. In addition the heat locally developed at the interface between the carrier and metal layer embedded therein results in a mechanical stress. In combination with gravity in an arrangement wherein the first side of the carrier faces downwards this also assists local removal of metal from the initial embedded metal layer. In this arrangement gravity also prevents that the removed metal is deposited on the carrier.

FIG. 4D shows the second side of the carrier comprising the modified embedded patterned metal structure EMM according to view D as indicated in FIG. 4C. As can be seen in FIG. 4D the interruptions partitions elements of the embedded patterned metal structure into mutually disconnected parts. Although in the embodiment shown herein the applied interruptions are arranged on a line, it will be understood that the interruptions may be applied according to any pattern that is desired for a particular application.

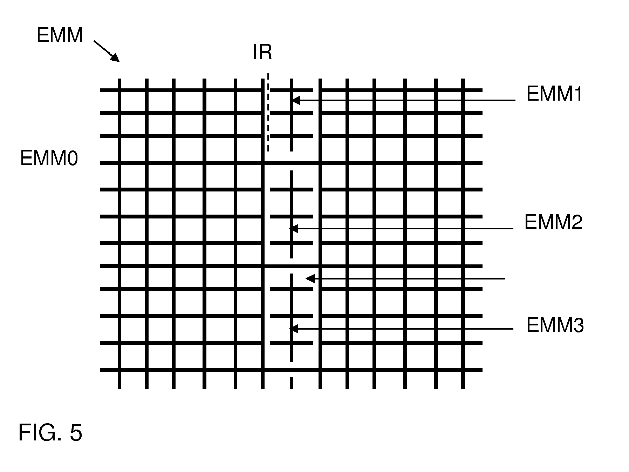

FIG. 5 shows an example wherein a modified embedded patterned metal structure EMM is provided having a main embedded metal structure part EMM0, and mutually insulated embedded metal structure parts EMM1, EMM2, EMM3.

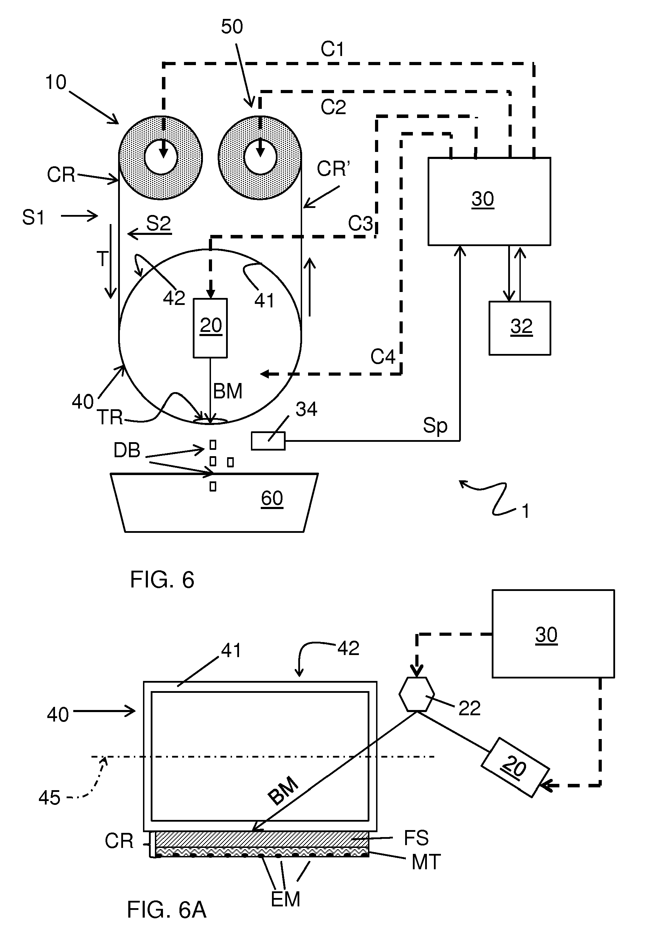

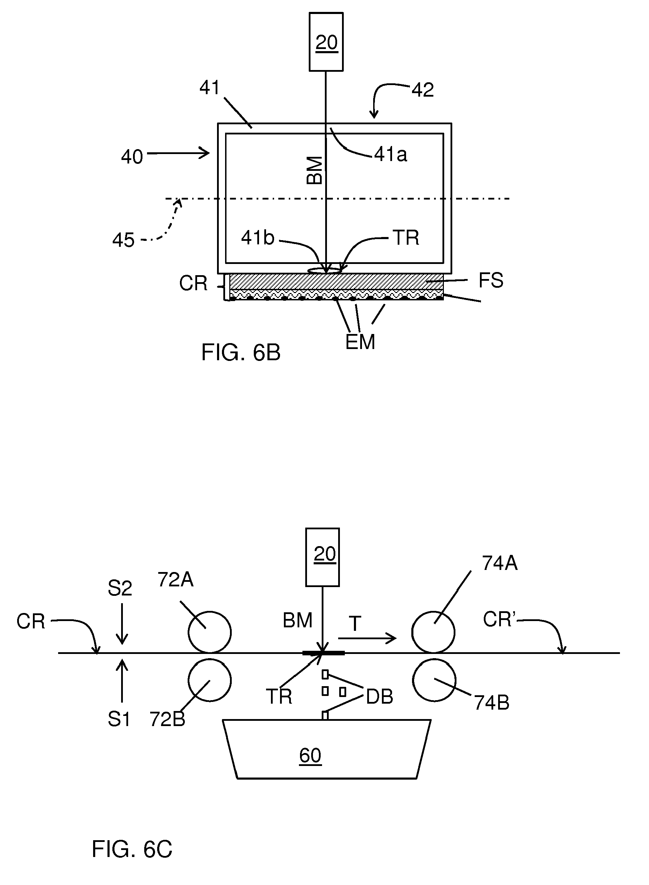

FIG. 6 shows a system according to the present invention arranged for providing a carrier including a polymer foil with an embedded patterned metal structure, the system 1 comprising a supply unit 10, here a supply roll, a radiation source 20, and a controller 30. The system further includes a drum 40, a storage roll 50, and a debris collection part 60 for collecting metal debris DB resulting from the process. In this case a circular cylindrical drum is shown. However alternatively a drum having another cross-section may be used, such as a drum in the form of an elliptical cylinder. In an embodiment the carrier supplied by the supply unit 10 may have a protective release layer at its first side S1 and the system may include a delamination unit that removes the protective release layer from the carrier supplied by the supply unit 10, to expose the embedded patterned metal structure for processing. A laminate unit may additionally be provided to cover the carrier with the processed embedded metal layer at its first side with a protective release layer before storing the processed carrier to the storage roll. FIG. 6 further shows a computer memory 32 and a sensor 34 that are functionally coupled to the controller 30. The sensor 34 determines the actual position of the foil and provides sense signal Sp indicative for the sensed actual position. The sensor 34 may be provided at any predetermined position along the path of the carrier CR, but is preferably arranged close to the target range TR of the radiation source 20. The sensor may for example being a visual recognition system. The computer memory 32 comprises instructions specifying the modification to be applied to the initial embedded metal structure embedded in the carrier CR provided by the supply roll 10. The controller 30 is arranged and programmed to control the apparatus. In the embodiment shown the controller provides control signals C1,..,C4 as indicated by dashed lines in the drawing. A first control signal C1 controls a motor for driving the supply roll 10. A second control signal C2 controls a motor for driving the storage roll 50. A third control signal C3 controls the radiation source. This control signal C3 may for example control for example an instantaneous fluence, a direction of the beam, and beam parameters, for example its cross-section. A fourth control signal C4 controls a motor for driving the drum 40. In the embodiment shown the controller 30 receives information Sp, signaled by the sensor 34, pertaining to a sensed current position of the foil. In response to this information Sp the controller adapts the control signals C1, ...,C4 to achieve that the initial embedded patterned metal structure is changed according to instructions received from memory 32.

More in particular, during operation, the controller 30 controls the supply unit to supply a carrier CR a first side S1 with an initial embedded patterned metal structure. The supplied carrier CR having at its first side S1 an initial embedded patterned metal structure, is for example a carrier as shown in and described with reference to figures 1A, ...1F and 2A, 2B.

During operation, the controller 30 further controls the radiation source 20 to irradiate the carrier at a second side S2 opposite the first side S1 with a radiation beam BM that is at least partially transmitted through the carrier CR and at least partially absorbed by the initial embedded patterned metal structure to therewith locally heating the initial embedded patterned metal structure and causing a removal of metal thereof.

In the embodiment shown the carrier CR is transported in a transport direction T along a target range TR of the radiation source 20. In this case a drum 40 is provided with a cylindrical wall 41, for example of glass or a transparent polymer such as PMMA. The drum 40 has an outer surface 42 that is arranged to guide the carrier CR on its second side S2 through the target range TR of the radiation source 20. The radiation source 20 is arranged to provide the radiation beam BM from inside the drum 40 through the cylindrical wall 41 of the drum to the second side S2 of the carrier CR. In this case the radiation source 20 itself is arranged inside the drum 40. Alternatively, as shown in FIG. 6A, the radiation source 20 may be arranged outside the drum 40 and the beam BM may be guided with optical elements such as lenses and mirrors to the target range TR. In the example of FIG. 6A a rotating hexagonal mirror 22 is provided.

Again another arrangement is shown in FIG. 6. Therein the radiation source 20 is positioned outside the drum 40 and the beam is directed via a first portion 41a and a second portion 41b of the wall 41 to the target area TR. Preferably the radiation beam traverses the first and the second portions 41a, 41b at an angle in the range between about 45 and 135 degrees, preferably at an angle close to 90 degrees to minimize a reflection at the cylindrical wall.

As can be seen in FIG. 6, the first side S1 of the carrier CR faces downwards at the location, the target range TR, where the carrier is irradiated. This facilitates removal of debris DB.

In this case the target range TR is a target line on the outer surface 42 of the drum 40 extending in a direction parallel to a rotation axis 45 of the drum. This target line coincides with the second side S2 of the carrier CR. A true two-dimensional area of the carrier CR is covered by transporting the carrier CR in a direction transverse to the direction of the target line. In the example of FIG. 6A, during operation, the controller 30 causes the hexagonal mirror 22 to rotate so that the beam BM generated by the radiation source is scanned along the target line TR. During operation the controller further modulates the fluence of the radiation source 20 in accordance with the pattern according to which metal is to be removed from the initial embedded metal structure MT. It is noted that for illustrative purposes the thickness of the carrier CR with the embedded metal layer EM in relation to the drum 40 is exaggerated. The controller 30 may further be programmed to take into account the effect of the angle of impact of the beam BM in the target range.

The resulting carrier CR' having the amended embedded patterned metal structure, for example as shown in FIG. 4C and 4D or FIG. 5 is then wound on a storage roll 50. The resulting carrier CR' may then be used in a later stage as a semi-finished product to manufacture electronic products on foil. Alternatively, a system as shown in FIG. 6 may be integrated with a manufacturing system for manufacturing electronic products on foil. In that case the resulting carrier CR' with the amended embedded patterned metal structure may be guided directly, for example by guiding rolls, to the manufacturing installation.

In the embodiment shown in FIG. 6 the supply unit provides the foil having the initial embedded patterned metal structure at its first side as a semi-finished product. This semi-finished product can be provided for a plurality of potential end-products and can in this way locally be modified for the desired particular end-product selected from the plurality of potential end-products.

Nevertheless, alternative embodiments may be conceived wherein the supply unit is a manufacturing stage that locally prepares the foil having the initial embedded patterned metal structure at its first side.

FIG. 6C shows an alternative embodiment, wherein the carrier CR having the initial embedded patterned metal structure is guided in the transport direction T along a plane. In the embodiment shown the carrier CR is transported by a first pair 72A, 72B and a second pair 74A, 74B of guide elements. In this case the guide element 72B, 74B are air-float carriers to prevent a physical contact with the first side S1 of the carrier CR. The guide element 72A, 74A are rollers that are driven by a motor.

By way of example, in this embodiment, the target range TR is an area, e.g. a rectangular area that extends in a direction T according to the transport direction and transverse to the transport direction in a plane coinciding with the second side S2 of the carrier CR. In this embodiment the guiding means may step-wise transport the carrier CR, each time over a distance corresponding to a size of the target range TR in the transport direction. Between two subsequent steps the beam BM is scanned over the target range TR.

Again other embodiments are possible wherein the target range TR of the radiation source 20 is a single spot, and wherein system has transportation facilities to transport the carrier CR in mutually transverse direction to achieve that the beam effectively scans the surface on the second side of the carrier CR.

In either of these embodiments it is not necessary that the beams scans each position on the second side. It is sufficient that those positions on the second side are scanned where metal has to be removed from the initial embedded patterned metal structure.

Experiments were carried out to investigate the invention presented herein, as described below.

### Experiment 1

A carrier provided at a first side with an initial embedded patterned metal structure was prepared. To that end a 125 micron thick, thermally stabilized PEN foil from Dupont-Tejin films was used upon which a patterned metal structure was printed formed by a set of parallel lines having a width varying in the range of 100 to 2000 micron. The patterned metal structure was deposited on the PEN-foil by screen printing. A DEK Horizon 03i screen printer with a SD40/25 400 mesh screen was used for this purpose.

Material Inktec TEC-PA-010 hybrid nano silver paste with a silver content of 55±10wt% was used. This silver paste is a blend of silver nano particles and a soluble silver complex.

The patterned metal structure was embedded in an Ormostamp resist layer.

In a next step the carrier with the initial embedded patterned metal structure was irradiated at its second side opposite the first side with a radiation beam from a pulsed infrared laser, here a Nd-YAG laser with a wavelength of 1064 nm, having a spot size in the range of 50 to 200 micrometer, here 100 micrometer. The laser, which scanned the second side at a speed of 5 m/sec, was operated pulse wise at a repetition rate of 200 kHz and a pulse width of about 10 ps.

The radiation beam was scanned over the second side of the carrier in a direction transverse to the direction of the embedded metal lines along ten of parallel tracks at mutually different laser fluence levels. The fluence (F) was stepwise increased with 0.1 J/cm² in the direction from the first track to the tenth track from 0.4 J/cm² to 1.4 J/cm².

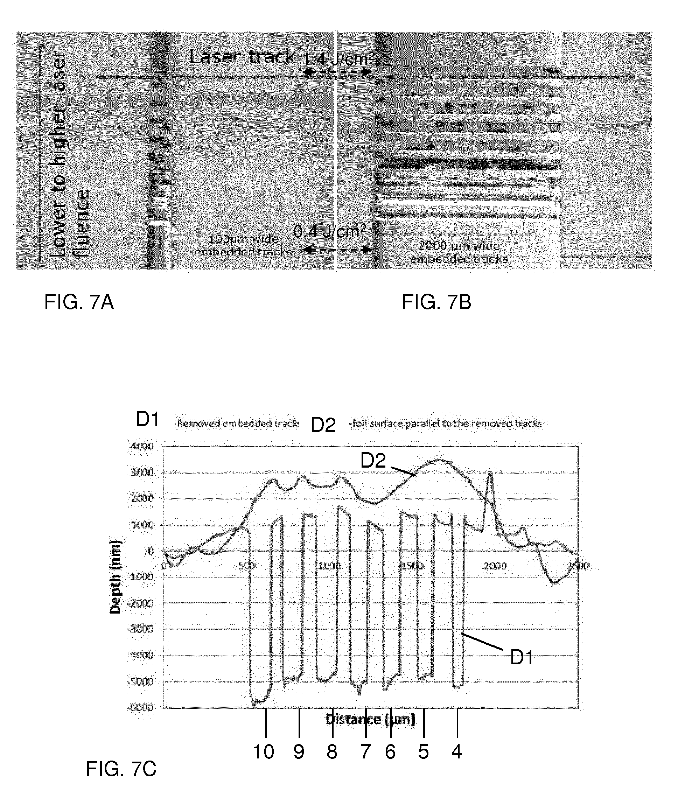

FIG. 7A shows a first part of the resulting embedded patterned metal structure formed by a line having a width of 100 micron. FIG. 7B shows a second part of the resulting embedded patterned metal structure formed by a line having a width of 2000 micron. Observations made are summarized in the following table. FIG. 7A also indicates the fluence of 0.4 J/cm² for the first scanline and the fluence of 1.4 J/cm² for the last scanline in this experiment.

| **F(J/cm²)** | **Line 100 micron** | **Line 2000 micron** |
|---|---|---|
| 0.4 | No metal removed | No metal removed |
| 0.5 | Metal partially removed | Metal partially removed |
| 0.6 | Metal partially removed | Metal partially removed |
| 0.7 | Metal partially removed | Metal partially removed |
| 0.8 | Metal partially removed | Metal partially removed |
| 0.9 | Metal substantially removed | Metal substantially removed |
| 1.0 | Metal substantially removed | Metal substantially removed |
| 1.1 | Metal substantially removed | Metal substantially removed |
| 1.2 | No residue left | Metal substantially removed |
| 1.3 | No residue left | Metal substantially removed |
| 1.4 | No residue left | Metal substantially removed |

From the observations presented above it is concluded that for the lines having a width of 100 micron a fluence setting of 0.9 J/cm² suffices to interrupt the electrical connection. Although some residue may be left this does not result in an electrical connection. If desired a fluence setting of 1.2 J/cm² and higher may be applied to remove all metal. For the wider lines of 2000 micron a somewhat lower fluence setting suffices for a substantial removal of the metal suitable to provide for an electric disconnection. It is presumed that for these wider lines the heat conducted laterally along the scanline of the laser contributes to removal of the metal. The experiment showed that metal removal step caused no damage to the embedding matrix formed by the Ormostamp resist or the PEN-layer. It is expected that such damage may occur if the fluence level is increased above 2 J/cm². To take into account tolerances in a practical production process it may be advisable to keep the fluence level below 75 % of this value, i.e. below 1.5 J/cm².

FIG. 7C shows a depth profile D1 obtained with a Dektak over a track along a metal line in a direction from a highest laser fluence setting, to a lowest laser fluence setting. For comparison, FIG. 7C further shows a depth profile D2 over a track alongside the metal line in the same direction.

It can be seen in FIG 7C that in the locations corresponding to fluence settings 4 to 9 the metal is removed over the full depth. The track prepared at the highest setting of 1.4 J/cm² has a slighter larger depth than the remaining tracks, indicating that some material of the carrier below the metal line is removed. Fluence.

### Experiment 2

In this second example a Suntronic Ag based ink was used to apply an initial patterned metal structure with a thickness of 150 nm. A Pixdro printer with Dimatix printer head was used for this purpose. The carrier in this case is a PEN foil with a moisture barrier having a WVTR of 10⁻⁶ g/m2/day at its first side. The moisture barrier was formed as a stack subsequently comprising an inorganic layer, an organic layer and an inorganic layer. The inorganic layers are of silicon oxide having a thickness of 100 nm. The organic layer is an acrylate having a thickness of 5 micrometer. The printed pattern in this case involves a single line.

In a next step the carrier with the initial patterned metal structure was irradiated at its second side opposite the first side with a radiation beam from a pulsed infrared laser as specified above.

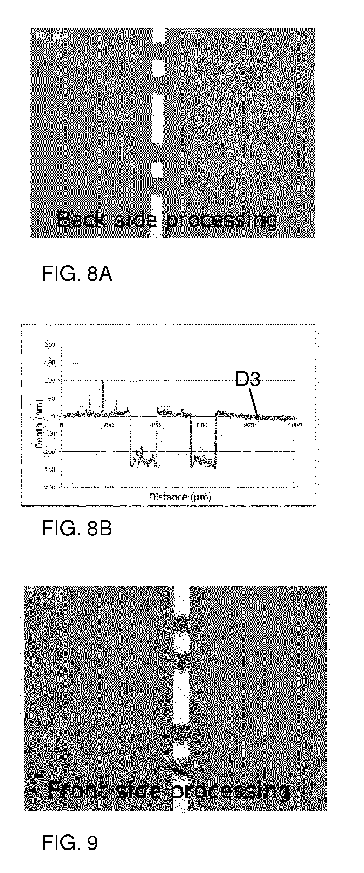

As a result of this treatment the resulting metal structure as shown in FIG. 8A was obtained. FIG. 8B shows a depth profile D3 obtained with a Dektak over a track along a length portion of the metal line.

### Experiment 3

As a counter example a similar sample was prepared as the one used for Example 2. However, in this case the carrier with the initial patterned metal structure was irradiated at its first side with a radiation beam from a pulsed infrared laser. In FIG. 9 it can be seen that the latter treatment causes damages to the surrounding material surrounding the location where metal is removed from the metal structure.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

As used herein, the terms "comprises," "comprising," "includes," "including," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

Also, use of the "a" or "an" are employed to describe elements and components of the invention. This is done merely for convenience and to give a general sense of the invention. This description should be read to include one or at least one and the singular also includes the plural unless it is obvious that it is meant otherwise.

Unless otherwise defined, all technical and scientific terms used herein have the same meaning as commonly understood by one of ordinary skill in the art to which this invention belongs. Although methods and materials similar or equivalent to those described herein can be used in the practice or testing of the present invention, suitable methods and materials are described below. All publications, patent applications, patents, and other references mentioned herein are incorporated by reference in their entirety. In case of conflict, the present specification, including definitions, will control. In addition, the materials, methods, and examples are illustrative only and not intended to be limiting.

## Claims

1. A method for providing a carrier (CR) with an embedded patterned metal structure (EMM), said carrier at least including a polymer foil (FS), the method comprising the steps of
- providing a carrier (CR) having a first side (S1) with an initial embedded patterned metal structure (EM),
- irradiating the carrier (CR) at a second side (S2) opposite the first side with a radiation beam (BM) that is at least partially transmitted through the carrier (CR) and at least partially absorbed by the initial embedded patterned metal structure (EM), therewith locally heating the initial embedded patterned metal structure and causing a removal of metal (DB) from the initial embedded patterned metal structure.

2. The method according to claim 1, wherein the first side (S1) of the carrier faces downwards at the location where the carrier is irradiated.

3. The method according to claim 1 or 2, wherein the step of irradiating comprises pulse wise applying the radiation beam.

4. The method according to claim 3, wherein said pulse wise applying comprises applying said radiation beam with pulses having a duration in the range of 1 ps to 50 ps.

5. The method of claim 1 or 2, wherein the patterned metal structure (EM) is embedded in the polymer foil (FS).

6. The method of claim 1 or 2, wherein the patterned metal structure (EM) is embedded in a matrix (MT) on the polymer foil.

7. The method of claim 6, wherein the matrix comprises at least a first ceramic layer (AL1).

8. The method of claim 7, wherein the matrix comprises a stack of layers including at least a first and a second ceramic layer (AL1, AL2).

9. The method of claim 8, wherein the stack of layers includes at least an organic layer (OL) between said at least a first and a second ceramic layer (AL1, AL2).

10. Method for manufacturing an electronic product on a carrier comprising all the steps of one of the previous claims and wherein said steps are succeeded by further steps involving at least deposition of one or more further layers on said first side (S1) of the carrier (CR).

11. A system arranged for providing a carrier with an embedded patterned metal structure, the carrier at least comprising a polymer foil, the system (1) comprising a supply unit (10), a radiation source (20), and a controller (30), the controller arranged and programmed to
- control the supply unit (10) to supply a carrier (CR), the carrier having a first side (S1) with an initial embedded patterned metal structure (EM),
- control the radiation source (20) to irradiate the carrier (CR) at a second side (S2) opposite the first side with a radiation beam (BM) that is at least partially transmitted through the carrier (CR) and at least partially absorbed by the initial embedded patterned metal structure (EM) to therewith locally heating the initial embedded patterned metal structure and causing a removal of metal thereof.

12. A system according to claim 11, wherein the carrier (CR) is transported in a transport direction (T) along a target range (TR) of the radiation source (20).

13. A system according to claim 12 having a drum (40) with a cylindrical wall (41) having an outer surface (42) arranged to guide the carrier (CR) on the second side (S2) of said carrier through the target range (TR) of the radiation source, and wherein the radiation source is arranged to provide the radiation beam from inside the drum through the cylindrical wall of the drum to the second side of the carrier.

14. A system according to claim 11 or 12, further comprising at least one sensor (34) for sensing a current position of the carrier CR and being functionally coupled to the controller to signal information (Sp) pertaining to the sensed current position.

15. System arranged for providing an electronic product on a polymer foil with an embedded patterned metal structure, the system comprising all the elements of any one of the claims 10 to 13, and in addition comprising at least one involving at least deposition of one or more further layers on said first side (S1) of the carrier (CR).
